(19)

Europäisches
Patentamt
European
Patent Office
Office européen
des brevets

(11) **EP 4 095 759 A1**

(12) **EUROPEAN PATENT APPLICATION**

(43) Date of publication:
**30.11.2022 Bulletin 2022/48**

(21) Application number: **21305677.3**

(22) Date of filing: **25.05.2021**

(51) International Patent Classification (IPC):
***G06N 3/063*** (2006.01) ***G06N 3/08*** (2006.01)
***G11C 11/00*** (2006.01)

(52) Cooperative Patent Classification (CPC):
**G06N 3/063; G06N 3/084; G11C 11/54;**
**G11C 13/0007; G11C 13/003; G11C 13/004;**
G11C 2213/79; G11C 2213/82

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicants:
• **Commissariat à l'énergie atomique**
**et aux énergies alternatives**
**75015 Paris (FR)**
• **Centre national de la recherche scientifique**
**75016 Paris (FR)**
• **Université Paris-Saclay**
**91190 Gif-sur-Yvette (FR)**

(72) Inventors:
• **HIRTZLIN, Tifenn**
**38054 Grenoble Cedex 9 (FR)**
• **QUERLIOZ, Damien**
**91120 Palaiseau (FR)**
• **VIANELLO, Elisa**
**38054 Grenoble Cedex 9 (FR)**

(74) Representative: **Lavoix**
**2, place d'Estienne d'Orves**
**75441 Paris Cedex 09 (FR)**

Remarks:
Amended claims in accordance with Rule 137(2)
EPC.

(54) **METHOD FOR TRAINING A BINARIZED NEURAL NETWORK AND RELATED ELECTRONIC CIRCUIT**

(57) This method for training a binarized neural network (BNN) including neurons, with a binary weight for each connection between two neurons, is implemented by an electronic circuit and comprises:
- a forward pass including calculating an output vector by applying the BNN on an input vector;
- a backward pass including computing an error vector between the calculated output vector and a learning output vector and calculating a new value of the input vector by applying the BNN on the error vector;
- a weight update including, for each binary weight, computing a product by multiplying an element of the error vector with one of the new value of the input vector, modifying a latent variable depending on the product; and updating the binary weight as a function of the latent variable;
each binary weight being encoded using a primary memory component ($W_{BLb,ij}$, $W_{BL,ij}$);
each latent variable being encoded using a secondary memory component ($M_{BLb,ij}$, $M_{BL,ij}$) having a characteristic subject to a time drift.

FIG.2

**Description**

**FIELD OF THE INVENTION**

The present invention relates to a method for training a binarized neural network, the binarized neural network including input neurons for receiving input values, output neurons for delivering output values and intermediate neurons between the input and output neurons, a respective binary weight being associated to each connection between two respective neurons (synaptic weight), the method being implemented by an electronic circuit using memory devices.
The invention also relates to an electronic circuit for operating such a binarized neural network, in particular for training said binarized neural network.

**BACKGROUND OF THE INVENTION**

The invention concerns the field of artificial neural networks, also called ANN, used in many areas of artificial intelligence: image recognition, speech recognition, optimization, etc.
The invention concerns in particular the field of binarized neural networks where both synapses and neurons can take binary values.
Currently, artificial neural networks are used in many areas of artificial intelligence. However, their training, also called learning, place significant demands on storage and computation involving an important energy consumption. This energy is due to the transfer of large quantities of information between the memory and processing units. Actually, there is no system capable of edge learning. Cloud computing platforms are used for the training phase and only the inference is performed at the edge.
Binarized neural networks, also called BNN, can be implemented using digital circuits. Therefore, they are very advanced in terms of hardware implementation. For example, low power implementations of BNN based on resistive memories have been recently proposed in the article "Digital Biologically Plausible Implementation of Binarized Neural Networks with Differential Hafnium Oxide Resistive Memory Arrays" from T. Hirtzlin et al, published in 2020 in Fontiers in Neuroscience.
Further, the article "Latent Weights Do Not Exist: Rethinking Binarized Neural Network Optimization" from K. Helwegen et al, published in 2019 for the 33rd Conference on Neural Information Processing Systems (NeurIPS 2019), describes a Binary Optimizer, referred to as BOP, algorithm designed for training BNN. This article teaches that in contrast to traditional real-valued supervised learning of ANN, with BNN there is the additional constraint to be a binary vector for a solution to a loss function used during the training of the BNN.
Usually, a global optimum to said loss function cannot be found. In real-valued networks an approximate solution via Stochastic Gradient-Descent (SGD) based methods are used instead. This challenge for evaluating the gradient when training a BNN is resolved by introducing during training an additional real value scalar for each synaptic weight, also called latent weight.
However, the BOP algorithm for training BNN and the SGD based methods require a computer and/or an external digital memory to store the latent weights to be implemented.
For training neural networks, the article "Equivalent-accuracy accelerated neural-network training using analogue memory" from S. Ambrogio et al, published in 2018 in Nature, describes an electronic circuit with analogue-memory unit cells, wherein each unit cell contains a pair of phase-change memory devices, also called PCM devices (labelled G+ and G-), and a volatile analogue conductance, in particular a volatile capacitor.
However, the need to add a capacitor per synaptic weight, i.e. per neuron, results in an important area overhead.
In addition, for training BNN, the article "Hybrid Analog-Digital Learning with Differential RRAM Synapses" from T. Hirtzlin et al, published in 2019 for IEEE International Electron Devices Meeting, teaches about the exploitation of the analog properties of a weak RESET in hafnium-oxide RRAM cells, also called OxRAM cells, while using compact and low power digital CMOS.
In contrast to the teaching of the article "A new hardware implementation approach of BNNs based on nonlinear 2T2R synaptic cell" from Z. Zhou et al, published in 2018 for IEEE International Electron Devices Meeting, a simple refresh mechanism allows to avoid saturation according to the article "Hybrid Analog-Digital Learning with Differential RRAM Synapses" from T. Hirtzlin et al.
Nonetheless, this solution suffers from some shortcomings. Firstly, the pulsed RESETs of the OxRAM cells are noisy; secondly, the learning algorithm requires to keep three variables in memory, one has to be stored on a computer or an external digital memory; and thirdly, these devices have limited endurance.

**SUMMARY OF THE INVENTION**

An object of the invention is therefore to provide a method and an associated electronic circuit for enabling on-chip training of a binarized neural network, without computer support.

For this purpose, the subject-matter of the invention is a method for training a binarized neural network, the binarized neural network including input neurons for receiving input values, output neurons for delivering output values and intermediate neurons between the input and output neurons, a respective binary weight being associated to each connection between two respective neurons, the method being implemented by an electronic circuit and comprising:

- a forward pass step including calculating an output vector by applying the binarized neural network on an input vector in a forward direction from the input neurons to the output neurons;
- a backward pass step including computing an error vector between the calculated output vector and a learning output vector and calculating a new value of the input vector by applying the binarized neural network on the error vector in a backward direction from the output neurons to the input neurons; and
- a weight update step including, for each binary weight:

  + computing a product by multiplying a respective element of the error vector with a respective element of the new value of the input vector;
  + modifying a latent variable depending on the product; and
  + updating the respective binary weight as a function of the latent variable with respect to a threshold;

  each binary weight being encoded using at least one primary memory component;
  each latent variable being encoded using at least one secondary memory component, each secondary memory component having a characteristic subject to a time drift.

With the training method according to the invention, each latent variable is encoded using at least one secondary memory component, each secondary memory component having a characteristic subject to a time drift. Therefore, the value of each latent variable drifts over time, in a similar manner to each latent weight verifying an exponential moving average of gradients according to the BOP algorithm for training BNN.

Thus, the training method uses this characteristic of the secondary memory components subject to the time drift to adapt the BOP algorithm for training BNN, so as to enable on-chip learning, i.e. on-chip training, for BNN.

According to other advantageous aspects of the invention, the training method comprises one or several of the following features, taken individually or according to any technically possible combination:

- each primary memory component has a characteristic subject to a time drift;
- the characteristic subject to the time drift is a conductance;
- each binary weight is encoded using two complementary primary memory components connected to a common sense line;
- each binary weight depends on respective conductance of the two complementary primary memory components;
- each binary weight verifies the following equation:

$$Wbin, ij = sign\left(\frac{G(W_{BLb,ij})}{G(W_{BL,ij})}\right)$$

where $W_{bin,ij}$ represents a respective binary weight,
sign is a sign function applied to an operand and issuing the value 1 if the operand is positive and -1 if the operand is negative, and
$G(W_{BLb,ij})$ and $G(W_{BL,ij})$ are the respective conductance of the two complementary primary memory components;

- each latent variable is encoded using two complementary secondary memory components connected to a common sense line;
- each latent variable depends on respective conductances of the two complementary secondary memory components;
- each latent variable verifies the following equation:

$$m_{ij} = G\left(M_{BLb,ij}\right) - G\left(M_{BL,ij}\right)$$

where $m_{ij}$ represents a respective latent variable, and
$G(M_{BLb,ij})$ and $G(M_{BL,ij})$ are the respective conductance of the two complementary secondary memory components;

- during the weight update step, each latent variable is modified depending on the sign of the respective product, each latent variable being preferably increased if the respective product is positive, and conversely decreased if said product is negative;
- during the weight update step, each binary weight is updated according to an algorithm including following first and second cases:

  <u>first case</u>: **if** $G(W_{BLb,ij}) < G(W_{BL,ij})$ and $G(M_{BLb,ij}) > G(M_{BL,ij})$ + Threshold1 **then** switch to $G(W_{BLb,ij}) > G(W_{BL,ij})$, preferably by increasing $G(W_{BLb,ij})$
  Threshold1 being preferably equal to $(G(W_{BLb,ij}) - G(W_{BL,ij}))$;
  <u>second case</u>: **if** $G(W_{BL,ij}) < G(W_{BLb,ij})$ and $G(M_{BL,ij}) > G(M_{BLb,ij})$ + Threshold2 **then** switch to $G(W_{BL,ij}) > G(W_{BLb,ij})$, preferably by increasing $G(W_{BL,ij})$,
  Threshold2 being preferably equal to $(G(W_{BL,ij}) - G(W_{BLb,ij}))$);

  where $G(W_{BLb,ij})$ and $G(W_{BL,ij})$ are the respective conductance of the two complementary primary memory components,
  $G(M_{BLb,ij})$ and $G(M_{BL,ij})$ are the respective conductance of the two complementary secondary memory components, and
  Threshold1, Threshold2 are respective thresholds;
  the algorithm preferably consisting of said first and second cases;

- each one of the primary and secondary memory components is a phase-change memory device;
- increasing the conductance of a respective memory component is obtained by applying a SET pulse to the corresponding phase-change memory device;

the SET pulse being preferably a low current pulse with a long duration, and
a RESET pulse being a high current pulse with a short duration.

The subject-matter of the invention is also an electronic circuit for operating a binarized neural network, the binarized neural network including input neurons for receiving input values, output neurons for delivering output values and intermediate neurons between the input and output neurons, a respective binary weight being associated to each connection between two respective neurons, a training of the binarized neural network comprising:

- a forward pass including calculating an output vector by applying the binarized neural network on an input vector in a forward direction from the input neurons to the output neurons;
- a backward pass including computing an error vector between the calculated output vector and a learning output vector and calculating a new value of the input vector by applying the binarized neural network on the error vector in a backward direction from the output neurons to the input neurons; and
- a weight update including, for each binary weight, computing a product by multiplying a respective element of the error vector with a respective element of the new value of the input vector; modifying a latent variable depending on the product; and updating the respective binary weight as a function of the latent variable with respect to a threshold;

the electronic circuit comprising a plurality of memory cells, each memory cell being associated to a respective binary weight, each memory cell including at least one primary memory component for encoding the respective binary weight; each memory cell further including at least one secondary memory component for encoding a respective latent variable, each latent variable being used for updating the respective binary weight, each secondary memory component having a characteristic subject to a time drift.

According to another advantageous aspect of the invention, the electronic circuit further comprises:

- a plurality of primary word lines to command the primary memory components;
- a plurality of secondary word lines to command the secondary memory components;
- a plurality of sense lines and bit lines connected to the memory cells;
- a first control module to control the primary word lines, the secondary word lines and the sense lines; and
- a second control module to control the bit lines;

a respective sense line being preferably connected to both primary and secondary memory components of a corresponding memory cell;
a respective bit line being preferably connected to both primary and secondary memory components of a corresponding memory cell.

## BRIEF DESCRIPTION OF THE DRAWINGS

The invention will be better understood upon reading of the following description, which is given solely by way of example and with reference to the appended drawings, wherein:

- Figure 1 is a schematic view of an electronic circuit, according to the invention, for operating a binarized neural network, in particular for training said binarized neural network, the electronic circuit comprising a plurality of memory cells, each memory cell being associated to a respective binary weight of the binarized neural network, only two successive layers of the binarized neural network being shown on this figure;
- Figure 2 is a schematic view of a respective memory cell of Figure 1, and of a pre-charge sense amplifier for operating the memory cell;
- Figure 3 is a flowchart of a process for operating the binarized neural network, the process including a training phase wherein a method according to the invention for training the binarized neural network is implemented, and then an inference phase wherein the trained binarized neural network is used to compute output values;
- Figure 4 is a set of curves representing a progressive increase of a conductance of memory components included in the memory cells of Figures 1 and 2, said conductance increase being obtained with multiple successive applications of a SET pulse; and
- Figure 5 is a set of curves showing alternating increases and decreases over time in the conductance of said memory components included in the memory cells of Figures 1 and 2, the conductance increases being obtained with SET pulses and the conductance decreases being due to time drifts.

## DETAILED DESCRIPTION

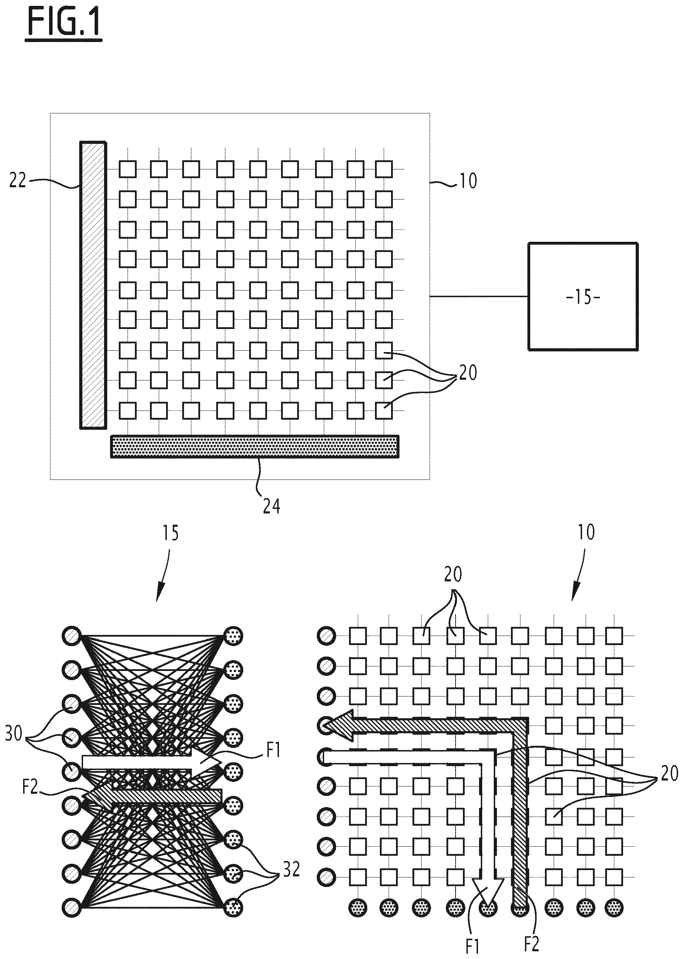

In Figure 1, an electronic circuit 10 is configured for operating a binarized neural network 15, also called BNN. In particular, the electronic circuit 10 is configured for training, i.e. for learning, the binarized neural network 15 and then configured for using the trained binarized neural network 15 to compute new output values from new input values. In other words, the electronic circuit 10 is preferably configured for both training and inference of the binarized neural network 15.

In this description, the terms "training" and "learning" are considered to be equivalent, i.e. to have the same meaning, and are therefore used interchangeably.

The electronic circuit 10 comprises a plurality of memory cells 20, each memory cell 20 being associated to a respective binary weight of the binarized neural network 15. In the example of Figure 1, the memory cells 20 are arranged in the form of a matrix, and the binary weights are also denoted $W_{bin,ij}$, where i is an index related to the columns of the matrix and j is an index related to the rows of said matrix.

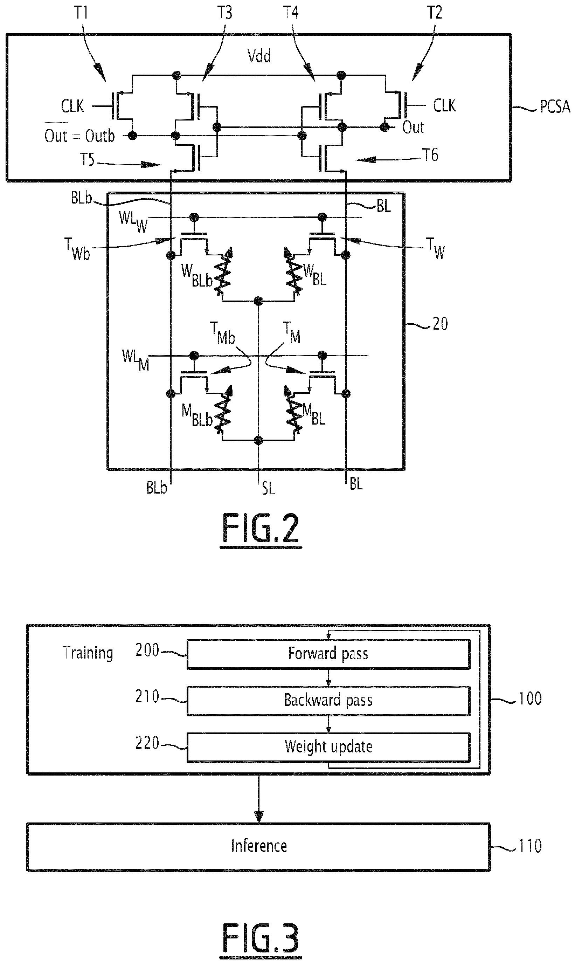

In the example of Figures 1 and 2, the electronic circuit 10 comprises a plurality of primary word lines $WL_{Wj}$, a plurality of secondary word lines $WL_{Mj}$ and a plurality of sense lines $SL_j$ and bit lines $BLb_i$, $BL_i$ connected to the memory cells 20. In the example of Figures 1 and 2, to each memory cell 20 is connected a pair of a respective primary word line $WL_{Wj}$ and a respective secondary word line $WL_{Mj}$, a respective sense line $SL_j$ and a pair of complementary bit lines $BLb_i$, $BL_i$, namely a first bit line $BLb_i$ and a second bit line $BL_i$. In the example of Figure 2, the primary word lines, the secondary word lines, the sense lines, the first bit lines and the second bit lines are respectively denoted $WL_W$, $WL_M$, SL and BLb, BL, i.e. without reciting the indexes i and j for sake of simplicity of the drawings.

In addition, the electronic circuit 10 comprises a plurality of pre-charge sense amplifiers PCSA, typically a pre-charge sense amplifier PCSA for each column of the matrix, in particular a pre-charge sense amplifier PCSA for each pair of complementary bit lines $BLb_i$, $BL_i$. As know *per se,* for example from the aforementioned article "Digital Biologically Plausible Implementation of Binarized Neural Networks with Differential Hafnium Oxide Resistive Memory Arrays" from T. Hirtzlin et al, the pre-charge sense amplifiers PCSA are configured for being used during readout operations of the memory cells 20. The pre-charge sense amplifiers PCSA are highly energy-efficient due to their operation in two phases, namely a pre-charge phase and a discharge phase, avoiding any direct path between a supply voltage and a ground. The high-energy efficiency is mainly due to the high speed of computation, the current flowing in the memory cells 20 during a very short amount of time, typically during some nanoseconds or some tens of nanoseconds. The operation of the pre-charge sense amplifier PCSA will be explained in more detail in a subsequent section of the description.

In addition, the electronic circuit 10 comprises a first control module 22 to control the primary word lines $WL_{Wj}$, the secondary word lines $WL_{Mj}$ and the sense lines $SL_j$; and a second control module 24 to control the first and second bit lines $BLb_i$, $BL_i$. Preferably, the first and second control modules 22, 24 allow to carry out a fully digital control of the primary word lines $WL_{Wj}$, the secondary word lines $WL_{Mj}$ and the sense lines $SL_j$, and respectively of the first and second bit lines $BLb_i$, $BL_i$.

The binarized neural network 15 includes input neurons for receiving input values, output neurons for delivering output values and intermediate neurons between the input and output neurons, a respective binary weight $W_{bin,ij}$ being associated to each connection between two respective neurons.

In the example of Figure 1, for sake of simplicity of the drawings, only two successive layers of the binarized neural network 15 are shown, namely a first layer with first neurons 30 and a second layer with second neurons 32, with multiple neuron connections between the first and second neurons 30, 32 and a respective binary weight $W_{bin,ij}$ associated to each neuron connection between two respective neurons 30, 32. The skilled person will understand that the first layer with first neurons 30 and the second layer with second neurons 32 are representative of any pair of successive layers of the binarized neural network 15.

As known *per se,* a training of the binarized neural network 15 comprises a forward pass including calculating an output vector $W_{bin}.X$ by applying the binarized neural network 15 on an input vector X in a forward direction from the input neurons to the output neurons, symbolized by an arrow F1 in Figure 1 from first neurons 30 to second neurons 32.

The training of the binarized neural network 15 further comprises a backward pass including computing an error vector dY between the calculated output vector $W_{bin}.X$ and a learning output vector $Y_{pred}$ and then calculating a new value of the input vector X by applying the binarized neural network 15 on the error vector dY in a backward direction from the output neurons to the input neurons, symbolized by an arrow F2 in Figure 1 from second neurons 32 to first neurons 30.

The training of the binarized neural network 15 finally comprises a weight update including, for each binary weight $W_{bin,ij}$, computing a product $g_{t,ij}$ by multiplying a respective element $dY_i$ of the error vector with a respective element $X_j$ of the new value of the input vector; then modifying a latent variable $m_{ij}$ depending on the product $g_{t,ij}$; and lastly updating the respective binary weight $W_{bin,ij}$ as a function of the latent variable $m_{ij}$ with respect to a threshold.

Each memory cell 20 includes at least one primary memory component $W_{BLb,ij}$, $W_{BL,ij}$ for encoding the respective binary weight $W_{bin,ij}$.

In optional addition, each memory cell 20 includes two complementary primary memory components $W_{BLb,ij}$, $W_{BL,ij}$, namely a first primary memory component $W_{BLb,ij}$ and a second primary memory component $W_{BL,ij}$, for encoding the respective binary weight $W_{bin,ij}$, these two complementary primary memory components $W_{BLb,ij}$, $W_{BL,ij}$ being connected to a common sense line $SL_j$.

According to the invention, each memory cell 20 further includes at least one secondary memory component $M_{BLb,ij}$, $M_{BL,ij}$ for encoding a respective latent variable $m_{ij}$, each latent variable $m_{ij}$ being used for updating the respective binary weight $W_{bin,ij}$.

In optional addition, each memory cell 20 includes two complementary secondary memory components $M_{BLb,ij}$, $M_{BL,ij}$, namely a first secondary memory component $M_{BLb,ij}$, and a second secondary memory component $M_{BL,ij}$, for encoding the respective latent variable $m_{ij}$, these two complementary secondary memory components $M_{BLb,ij}$, $M_{BL,ij}$ being connected to the common sense line $SL_j$.

Each memory cell 20 includes for example two complementary primary memory components $W_{BLb,ij}$, $W_{BL,ij}$, two complementary secondary memory components $M_{BLb,ij}$, $M_{BL,ij}$ and four switching components $T_{Wb,ij}$, $T_{W,ij}$, $T_{Mb,ij}$, $T_{M,ij}$, each switching component $T_{Wb,ij}$, $T_{W,ij}$, $T_{Mb,ij}$, $T_{M,ij}$ being connected to a respective memory component $W_{BLb,ij}$, $W_{BL,ij}$, $M_{BLb,ij}$, $M_{BL,ij}$, as shown in Figure 2. Accordingly, each memory cell 20 includes a first primary switching component $T_{Wb,ij}$ connected to the first primary memory component $W_{BLb,ij}$ and a second primary switching component $T_{W,ij}$ connected to the second primary memory component $W_{BL,ij}$. Similarly, each memory cell 20 includes a first secondary switching component $T_{Mb,ij}$ connected to the first secondary memory component $M_{BLb,ij}$ and a second secondary switching component $T_{M,ij}$ connected to the second secondary memory component $M_{BL,ij}$.

In the example of Figure 2, each switching component $T_{Wb,ij}$, $T_{W,ij}$, $T_{Mb,ij}$, $T_{M,ij}$ is a transistor, such a FET (for Field-Effect Transistor), in particular a MOSFET for (Metal-Oxide-Semiconductor Field-Effect Transistor), also known as a MOS (for Metal-Oxide-Silicon) transistor, for example a NMOS transistor.

In the example of Figure 2, each switching component $T_{Wb,ij}$, $T_{W,ij}$, $T_{Mb,ij}$, $T_{M,ij}$ in form of a respective transistor has a gate electrode, a source electrode and a drain electrode; and is connected via its gate electrode to a respective word line $WL_{Wj}$, $WL_{Mj}$, via its drain electrode to a respective bit line $BLb_i$, $BL_i$ and via its source electrode to one of the two electrodes of a respective memory component $W_{BLb,ij}$, $W_{BL,ij}$, $M_{BLb,ij}$, $M_{BL,ij}$, the other electrode of said memory component $W_{BLb,ij}$, $W_{BL,ij}$, $M_{BLb,ij}$, $M_{BL,ij}$ being connected to a respective sense line $SL_j$.

In other words, a respective sense line $SL_j$ is preferably connected to both primary $W_{BLb,ij}$, $W_{BL,ij}$ and secondary $M_{BLb,ij}$, $M_{BL,ij}$ memory components of a corresponding memory cell 20. A respective bit line $BLbi$, $BL_i$ is preferably connected to both primary $W_{BLb,ij}$, $W_{BL,ij}$ and secondary $M_{BLb,ij}$, $M_{BL,ij}$ memory components of a corresponding memory cell 20. In particular, the first bit line $BLbi$ is preferably connected to both first primary $W_{BLb,ij}$ and first secondary $M_{BLb,ij}$ memory components of a respective memory cell 20; and the second bit line $BL_i$ is preferably connected to both second primary $W_{BL,ij}$ and second secondary $M_{BL,ij}$ memory components of this respective memory cell 20.

In the example of Figure 2, each memory cell 20 is configured in a 4T4R structure wherein the four switching components, such as the four transistors $T_{Wb,ij}$, $T_{W,ij}$, $T_{Mb,ij}$, $T_{M,ij}$, correspond to the "4T" and the four memory component

$W_{BLb,ij}$, $W_{BL,ij}$, $M_{BLb,ij}$, $M_{BL,ij}$ correspond to the "4R".

Each pre-charge sense amplifier PCSA includes for example six switching components T1, T2, T3, T4, T5, T6, namely a first switching component T1, a second switching component T2, a third switching component T3, a fourth switching component T4, a fifth switching component T5 and a sixth switching component T6, as shown in Figure 2. Each switching component T1, T2, T3, T4, T5, T6 has two conduction electrodes and a control electrode. In the example of Figure 2, each switching component T1, T2, T3, T4, T5, T6 is a transistor, such a FET, in particular a MOSFET or MOS transistor. Accordingly, the two conduction electrodes are a source electrode and a drain electrode; and the control electrode is a gate electrode.

Each pre-charge sense amplifier PCSA is connected to a supply line Vdd; to a clock line CLK; and two complementary output lines, namely a first output line Out and a second output line Outb complementary to the first output line Out.

In the example of Figure 2, the first switching component T1 is connected via its conduction electrodes between the supply line Vdd and the second output line Outb and via its control electrode to the clock line CLK. The second switching component T2 is connected via its conduction electrodes between the supply line Vdd and the first output line Out and via its control electrode to the clock line CLK. In the example of Figure 2, the first and second switching components T1, T2 are PMOS, with their source electrode connected to the supply line Vdd.

In the example of Figure 2, the third switching component T3 is connected via its conduction electrodes between the supply line Vdd and the second output line Outb and via its control electrode to the first output line Out. The fourth switching component T4 is connected via its conduction electrodes between the supply line Vdd and the first output line Out and via its control electrode to the second output line Outb. In the example of Figure 2, the third and fourth switching components T3, T4 are PMOS, with their source electrode connected to the supply line Vdd.

In the example of Figure 2, the fifth switching component T5 is connected via its conduction electrodes between the second output line Outb and the first bit line BLb and via its control electrode to the first output line Out. The sixth switching component T6 is connected via its conduction electrodes between the first output line Out and the second bit line BL and via its control electrode to the second output line Outb. In the example of Figure 2, the fifth and sixth switching components T5, T6 are NMOS, with their source electrode connected to the respective bit line BL, BLb.

In the example of Figure 2 and in a conventional manner, the electric connection between an electrode and a respective line is symbolized by a dot; and the crossing of two lines without a dot at the intersection of these two lines corresponds to an absence of electrical connection between these two lines.

In the example of Figure 2, the primary memory components and respectively the secondary memory components are denoted $W_{BLb}$, $W_{BL}$ and respectively $M_{BLb}$, $M_{BL}$, i.e. without reciting the indexes i and j for sake of simplicity of the drawings. Similarly, the primary switching components and respectively the secondary switching components are denoted $T_{Wb}$, Tw and respectively $T_{Mb}$, $T_M$, i.e. without reciting the indexes i and j for sake of simplicity of the drawings.

The first control module 22 is configured to control the primary word lines $WL_{Wj}$, the secondary word lines $WL_{Mj}$ and the sense lines $SL_j$. As previously described, the primary word lines WLwj are configured for controlling the primary memory components $W_{BLb,ij}$, $W_{BL,ij}$; and the secondary word lines $WL_{Mj}$ are configured for controlling the secondary memory components $M_{BLb,ij}$, $M_{BL,ij}$.

The second control module 24 is configured to control the first and second bit lines $BLb_i$, $BL_i$.

The first control module 22 and the second control module 24 are configured to be piloted in a coordinated manner, known *per se*, for example with the RAM (for Random Access Memory) technology, so as to operate the memory cells 20, in particular the primary memory components $W_{BLb,ij}$, $W_{BL,ij}$ and/or the secondary memory components $M_{BLb,ij}$, $M_{BL,ij}$, according to well-known memory operation states, namely a hold state for keeping a value contained in a respective memory component $W_{BLb,ij}$, $W_{BL,ij}$, $M_{BLb,ij}$, $M_{BL,ij}$, a write state for writing a new value in a respective memory component $W_{BLb,ij}$, $W_{BL,ij}$, $M_{BLb,ij}$, $M_{BL,ij}$, and a read state for reading the value of a respective memory component $W_{BLb,ij}$, $W_{BL,ij}$, $M_{BLb,ij}$, $M_{BL,ij}$.

Each primary memory component $W_{BLb,ij}$, $W_{BL,ij}$ has a characteristic subject to a time drift. The characteristic subject to the time drift for each primary memory component $W_{BLb,ij}$, $W_{BL,ij}$ is for example a conductance, respectively denoted $G(W_{BLb,ij})$, $G(W_{BL,ij})$.

Each primary memory component $W_{BLb,ij}$, $W_{BL,ij}$ is typically a resistive memory device. Each primary memory component $W_{BLb,ij}$, $W_{BL,ij}$ is for example a phase-change memory device. Alternatively, each primary memory component $W_{BLb,ij}$, $W_{BL,ij}$ is an hafnium-oxide resistive random-access memory device, also called hafnium-oxide RRAM device or OxRAM device; a conductive bridging random-access memory device, also called CBRAM device; a magnetic random-access memory device, also called MRAM device; or a ferroelectric memory device.

Each secondary memory component $M_{BLb,ij}$, $M_{BL,ij}$ has a characteristic subject to a time drift. The characteristic subject to the time drift secondary memory component $M_{BLb,ij}$, $M_{BL,ij}$ is for example a conductance, respectively denoted, $G(M_{BLb,ij})$, $G(M_{BL,ij})$.

Each secondary memory component $M_{BLb,ij}$, $M_{BL,ij}$ is preferably a phase-change memory device. Alternatively, each secondary memory component $M_{BLb,ij}$, $M_{BL,ij}$ is an hafnium-oxide resistive random-access memory device, also called hafnium-oxide RRAM device or OxRAM device; or a volatile conductive bridging random-access memory device, also called volatile CBRAM device.

The phase-change memory device is also known as PCM (for Phase Change Memory), PRAM (for Phase-change Random Access Memory), PCRAM (for Phase Change RAM), OUM (for Ovonic Unified Memory) and C-RAM or CRAM (for Chalcogenide Random Access Memory) device. The phase-change memory device is a type of non-volatile random-access memory.

The phase-change memory devices generally exploit the unique behavior of chalcogenide materials. For some phase-change memory devices, heat produced by the flow of an electric current through a heating element generally made of titanium nitride was used to either quickly heat and quench the chalcogenide material, making it amorphous, or to hold it in its crystallization temperature range for some time, thereby switching it to a crystalline state.

The phase-change memory device also has the ability to achieve a number of distinct intermediary states, thereby having the ability to hold multiple bits in a single cell.

The operation of the electronic circuit 10 according to the invention will now be explained in view of Figure 3 representing a flowchart of a process for operating the binarized neural network 15 with the electronic circuit 10, the process including a training phase 100 wherein a method according to the invention for training the binarized neural network 15 is implemented, and then an inference phase 110 wherein the trained binarized neural network 15 is used to compute output values.

The training phase 100 includes a forward pass step 200, followed by a backward pass step 210 and then a weight update step 220.

The forward pass step 200, the backward pass step 210 and the weight update step 220 are carried out an iterative manner, a new forward pass step 200 being carried out after a previous weight update step 220, until the binarized neural network 15 is properly trained, i.e. until a solution is found to a loss function between an output vector $W_{bin}.X$ calculated by applying the binarized neural network 15 on the input vector X and a learning output vector $Y_{pred}$, said solution minimizing the loss function corresponding to an optimal binary weight vector $Y_{ref}$.

During the forward pass step 200, the electronic circuit 10 calculates the output vector $W_{bin}.X$ by applying the binarized neural network 15 on the input vector X in the forward direction F1 from the input neurons to the output neurons, in particular from first neurons 30 to second neurons 32.

When a classical neural network is applied to an input vector so as to calculate an output vector, each neuron receives input values corresponding to the output values of the neurons of a previous layer $a_j$ and performs a weighted sum $\sum_j W_{ij}.a_j$, and then it applies a non-linear function $f$ to the result of this weighted sum.

With the binarized neural network 15, the weighted sum is obtained by performing the following equation:

$$a_i = sign[popcount_j\,XNOR(W_{bin,ij}, a_j) - T_i] \qquad (1)$$

where $a_i$ represent the output values calculated with the neurons of the current layer;

$W_{bin,ij}$ represents the respective binary weights for the neurons of the current layer;

$a_j$ represent the input values for the neurons of the current layer, i.e. the output values of the neurons of the previous layer;

XNOR is a function returning logical complement of the Exclusive OR;

popcount is a function that counts the number of 1 in a series of bits;

$T_i$ is a predefined threshold; and

sign is a sign function applied to an operand and issuing the value 1 if the operand is positive and -1 if the operand is negative.

In other words, the product becomes a logic gate XNOR between the binary weight $W_{bin}$ and the presynaptic neuron activation aj, the sum becomes the popcount function, then a comparison with the threshold $T_i$, gives the binary output 1 or -1 if the value is respectively above or below this threshold. Preferably, this comparison gives an instruction if the binary output value has to be changed or not.

After the forward pass step 200, the electronic circuit 10 then computes the error vector dY between the calculated output vector $W_{bin}.X$ and the learning output vector $Y_{pred}$ and further calculates, during the next backward pass step 210, the new value of the input vector X by applying the binarized neural network 15 on the error vector dY in the backward direction F2 from the output neurons to the input neurons, in particular from second neurons 32 to first neurons 30.

Further to the backward pass step 210, the electronic circuit 10 finally updates the value of each each binary weight $W_{bin,ij}$ during the weight update step 220.

During this weight update step 220, the electronic circuit 10 first computes the product $g_{t,ij}$ by multiplying a respective element $dY_i$ of the error vector with a respective element $X_j$ of the new value of the input vector, then modifies

the latent variable $m_{ij}$ depending on the product $g_{t,ij}$; and lastly updates the respective binary weight $W_{bin,ij}$ as a function of the latent variable $m_{ij}$ with respect to a respective threshold.

During the training phase 100, and also during the subsequent inference phase 110, each binary weight $W_{bin,ij}$ is preferably encoded using the two complementary primary memory components $W_{BLb,ij}$, $W_{BL,ij}$.

In this example, each binary weight $W_{bin,ij}$ typically depends on respective conductances $G(W_{BLb,ij})$, $G(W_{BL,ij})$ of the two complementary primary memory components $W_{BLb,ij}$, $W_{BL,ij}$.

Each binary weight $W_{bin,ij}$ verifies typically the following equation:

$$Wbin, ij = sign\left(\frac{G(W_{BLb,ij})}{G(W_{BL,ij})}\right) \qquad (2)$$

where $W_{bin,ij}$ represents a respective binary weight,
sign is a sign function applied to an operand and issuing the value 1 if the operand is positive and -1 if the operand is negative, and
$G(W_{BLb,ij})$ and $G(W_{BL,ij})$ are the respective conductance of the two complementary primary memory components $W_{BLb,ij}$, $W_{BL,ij}$.

According to this example with the two complementary primary memory components $W_{BLb,ij}$, $W_{BL,ij}$, for obtaining a binary weight $W_{bin,ij}$ value, first, a clock signal on the clock line CLK is set to the ground in the respective pre-charge sense amplifier PCSA and the sense line $SL_j$ to the supply voltage, which precharges the two selected complementary primary memory components $W_{BLb,ij}$, $W_{BL,ij}$ as well as a comparing latch formed by the third and fourth switching components T3, T4 at the same voltage.

Second, the clock signal on the clock line CLK is set to the supply voltage, the sense line $SL_j$ is set to the ground and the voltages on the complementary primary memory components $W_{BLb,ij}$, $W_{BL,ij}$ are discharged to the ground through the sense line $SL_j$. The branch, i.e. the first bit line BLbi or the second bit line $BL_j$, with the lowest resistance discharges faster and causes its associated inverter output, i.e. the fifth T5 or sixth T6 switching component, to discharge to the ground, which latches the complementary inverter output, i.e. the sixth T6 or fifth T5 switching component, to the supply voltage. The two output voltages in the two complementary output lines Out, Outb therefore represent the comparison of the two complementary conductance values $G(W_{BLb,ij})$, $G(W_{BL,ij})$.

During the forward pass step 200 and the backward pass step 210, the electronic circuit 10, in particular the first control module 22, only selects the word line corresponding to the binary weight $W_{bin,ij}$, i.e. the respective primary word line $WL_{Wj}$. When this word line is the only one selected and as described above, the pre-charge sense amplifier PCSA outputs a binary output value corresponding to the binary weight $W_{bin,ij}$ which is usable to perform forward and backward calculations.

Then, during the weight update step 220, this time the electronic circuit 10, in particular the first control module 22, activates the respective secondary word line $WL_{Mj}$ to update the conductances $G(M_{BLb,ij})$, $G(M_{BL,ij})$ of the two complementary secondary memory components $M_{BLb,ij}$, $M_{BL,ij}$, preferably according to the sign of the respective product $g_{t,ij}$.

In addition, during the weight update step 220, each latent variable $m_{ij}$ is preferably encoded using the two complementary secondary memory components $M_{BLb,ij}$, $M_{BL,ij}$.

In this example, each latent variable $m_{ij}$ depends on respective conductances $G(M_{BLb,ij})$, $G(M_{BL,ij})$ of the two complementary secondary memory components $M_{BLb,ij}$, $M_{BL,ij}$.

Each latent variable $m_{ij}$ verifies for example the following equation:

$$m_{ij} = G\left(M_{BLb,ij}\right) - G\left(M_{BL,ij}\right) \qquad (3)$$

where $m_{ij}$ represents a respective latent variable, and
$G(M_{BLb,ij})$ and $G(M_{BL,ij})$ are the respective conductance of the two complementary secondary memory components $M_{BLb,ij}$, $M_{BL,ij}$.

During the weight update step 220, each latent variable $m_{ij}$ is preferably modified depending on the sign of the respective product $g_{t,ij}$. Each latent variable $m_{ij}$ is for example increased if the respective product $g_{t,ij}$ is positive, and conversely decreased if said product $g_{t,ij}$ is negative.

At the end of the weight update step 220, the electronic circuit 10, in particular the first and second control modules 22, 24, perform a reading to compare a $(G(M_{BLb,ij}) - G(M_{BL,ij}))$ conductance difference with a threshold Threshold1, Threshold2 by activating both respective primary word line $WL_{Wj}$ and respective secondary word line $WL_{Mj}$.

When carrying out this double word line activation, the value read by the pre-charge amplifier PCSA is different from the stored binary weight $W_{bin,ij}$ if and only if the difference in conductance is higher than the threshold Threshold1, Threshold2.

Preferably, the threshold Threshold1, Threshold2 is directly coded in the binary weight $W_{bin,ij}$, i.e. with the respective conductances $G(W_{BLb,ij})$, $G(W_{BL,ij})$ of the two complementary primary memory components $W_{BLb,ij}$, $W_{BL,ij}$. Accordingly, a first threshold Threshold1 is preferably equal to $(G(W_{BLb,ij}) - G(W_{BL,ij}))$; and a second threshold Threshold2 is preferably equal to $(G(W_{BL,ij}) - G(W_{BLb,ij}))$.

During the weight update step 220, each binary weight $W_{bin,ij}$ is then updated for example according to an algorithm including following first and second cases:

first case: **if** $G(W_{BLb,ij}) < G(W_{BL,ij})$ and $G(M_{BLb,ij}) > G(M_{BL,ij})$ + Threshold1 **then** switch to $G(W_{BLb,ij}) > G(W_{BL,ij})$,
second case: **if** $G(W_{BL,ij}) < G(W_{BLb,ij})$ and $G(M_{BL,ij}) > G(M_{BLb,ij})$ + Threshold2 **then** switch to $G(W_{BL,ij}) > G(W_{BLb,ij})$,

where $G(W_{BLb,ij})$ and $G(W_{BL,ij})$ are the respective conductance of the two complementary primary memory components $W_{BLb,ij}$, $W_{BL,ij}$,
$G(M_{BLb,ij})$ and $G(M_{BL,ij})$ are the respective conductance of the two complementary secondary memory components $M_{BLb,ij}$, $M_{BL,ij}$, and
Threshold1, Threshold2 are respectively the first and second thresholds.

The aforementioned algorithm to update each binary weight $W_{bin,ij}$ preferably consists of said first and second cases.

By example, for implementing the aforementioned algorithm, the electronic circuit 10, in particular the first and second control modules 22, 24, perform a first read to detect if $G(W_{BLb,ij}) < G(W_{BL,ij})$ determining therefore that the first case applies or else if $G(W_{BL,ij}) < G(W_{BLb,ij})$ determining therefore that the second case applies. The first read is performed by selecting only the respective primary word line WLwj.

Then, the electronic circuit 10, in particular the first and second control modules 22, 24, perform a second read to detect if $G(M_{BLb,ij}) > G(M_{BL,ij})$ + Threshold1, preferably if $G(M_{BLb,ij}) > G(M_{BL,ij}) + G(W_{BLb,ij}) - G(W_{BL,ij})$, if the first case was determined further to the first read; or else to detect if $G(M_{BL,ij}) > G(M_{BLb,ij})$ + Threshold2, preferably if $G(M_{BL,ij}) > G(M_{BLb,ij}) + G(W_{BL,ij}) - G(W_{BLb,ij})$, if the second case was determined further to the first read. The second read is performed by selecting both the respective primary $WL_{Wj}$ and secondary $WL_{Mj}$ word lines.

For performing each one of the first read and the second read, the following actions are carried out, the only difference between the first read and the second read being the difference in the word line selection, namely only the respective primary word line $WL_{Wj}$ for the first read, while both the respective primary $WL_{Wj}$ and secondary $WL_{Mj}$ word lines for the second read.

Accordingly, for a given read among the first read and the second read, firstly, the sense line $SL_j$ is charged at supply voltage and the clock signal on the clock line CLK is set to the ground. With the clock signal on the clock line CLK set to the ground, the first and second switching components T1, T2, typically PMOS transistors, are turned on, and the supply voltage is applied at the two output voltages in the two complementary output lines Out, Outb of the latch.

Secondly, the voltages are discharged at the primary $W_{BLb,ij}$, $W_{BL,ij}$ and secondary $M_{BLb,ij}$, $M_{BL,ij}$ memory components, to the ground through the sense line $SL_j$. This is achieved by setting the clock signal on the clock line CLK to the supply voltage and the sense line $SL_j$ to the ground. Considering that the latches of the pre-charge amplifier PCSA, i.e. the two complementary output lines Out, Outb, are both at supply voltages, the fifth and sixth switching components T5, T6, typically NMOS transistors, are turned on, letting current flow through the branches of the primary memory components $W_{BLb,ij}$, $W_{BL,ij}$ when only the respective primary word line $WL_{Wj}$ is activated; or else through the branches of the primary $W_{BLb,ij}$, $W_{BL,ij}$ and secondary $M_{BLb,ij}$, $M_{BL,ij}$ memory components when both the respective primary $WL_{Wj}$ and secondary $WL_{Mj}$ word lines are activated. Then, since the memory components $W_{BLb,ij}$, $W_{BL,ij}$, $M_{BLb,ij}$, $M_{BL,ij}$ have different resistances, the discharge speed is not the same in each of the branches, i.e. in the first bit line BLbi and in the second bit line $BL_i$. Because the current is greater in the low-resistance branch, the low resistance branch discharges faster. The state of the branch of the latch with low resistance will decrease faster than the other with high resistance; this disequilibrium will be amplified until the state of the high current branch discharges to the ground controlling the PMOS transistor in the complementary branch. Therefore, the PMOS transistor of the other branch is charged to Vdd.

The state of the latch, i.e. of the respective complementary output lines Out, Outb, therefore allows comparing $G(W_{BLb,ij})$ with $G(W_{BL,ij})$ in case of the first read; or else comparing the sum $(G(W_{BLb,ij}) + G(M_{BLb,ij}))$ with the sum $(G(W_{BL,ij}) + G(M_{BL,ij}))$ in case of the second read, i.e. carrying out the comparison $G(M_{BLb,ij}) > G(M_{BL,ij})$ + Threshold1 with Threshold1 equal to $(G(W_{BLb,ij}) - G(W_{BL,ij}))$ or the comparison $G(M_{BL,ij}) > G(M_{BLb,ij})$ + Threshold2 with Threshold2 equal to $(G(W_{BL,ij}) - G(W_{BLb,ij}))$.

The electronic circuit 10, in particular the first and second control modules 22, 24, preferably perform these operations row by row, so that only one bit register per column of the matrix is required.

With the aforementioned algorithm, In the first case, if a switch to $G(W_{BLb,ij}) > G(W_{BL,ij})$ is commanded, this switch from $G(W_{BLb,ij}) < G(W_{BL,ij})$ to $G(W_{BLb,ij}) > G(W_{BL,ij})$ is typically carried out by increasing the conductance $G(W_{BLb,ij})$.

Similarly, in the second case, if a switch to $G(W_{BL,ij}) > G(W_{BLb,ij})$ is commanded, this switch from $G(W_{BL,ij}) < G(W_{BLb,ij})$ to $G(W_{BL,ij}) > G(W_{BLb,ij})$ is typically carried out by increasing the conductance $G(W_{BL,ij})$.

In optional addition, when the primary memory components $W_{BLb,ij}$, $W_{BL,ij}$, respectively the secondary memory components $M_{BLb,ij}$, $M_{BL,ij}$, are phase-change memory devices, increasing the conductance $G(W_{BLb,ij})$, $G(W_{BL,ij})$, $G(M_{BLb,ij})$, $G(M_{BL,ij})$ of a respective memory component $W_{BLb,ij}$, $W_{BL,ij}$, $M_{BLb,ij}$, $M_{BL,ij}$ is obtained by applying a SET pulse to the corresponding phase-change memory device.

In further optional addition, the switch from $G(W_{BLb,ij}) < G(W_{BL,ij})$ to $G(W_{BLb,ij}) > G(W_{BL,ij})$ is preferably obtained by applying the SET pulse to the memory component $W_{BLb,ij}$ and a RESET pulse to the memory component $W_{BL,ij}$. Similarly, the switch from $G(W_{BL,ij}) < G(W_{BLb,ij})$ to $G(W_{BL,ij}) > G(W_{BLb,ij})$ is preferably obtained by applying the SET pulse to the memory component $W_{BL,ij}$ and the RESET pulse to the memory component $W_{BLb,ij}$.

As known *per se,* the SET pulse is typically a low current pulse with a long duration, and the RESET pulse is typically a high current pulse with a short duration.

As an example, to apply the SET pulse to a respective memory component $W_{BLb,ij}$, $W_{BL,ij}$, $M_{BLb,ij}$, $M_{BL,ij}$, in particular to a PCM device, the corresponding bit line $BLb_j$, $BL_j$ is set to the ground, while the sense line $SL_i$ is set to a predefined SET voltage, typically 1.2 V, for a progressive set behavior with a small pulse duration, typically comprised between 100 ns and 200 ns. The SET pulse applied to the PCM device includes for example a first ramp lasting about 100 ns with increasing value from 0V to 1.2V, a second ramp lasting about 20 ns with constant value equal to 1.2V, and a third ramp lasting about 20 ns with decreasing value from 1.2V to 0V.

Alternatively, when the respective memory component $W_{BLb,ij}$, $W_{BL,ij}$, $M_{BLb,ij}$, $M_{BL,ij}$, is an OxRAM device, to apply the SET pulse, the corresponding bit line $BLb_j$, $BL_j$ is set to the ground, while the sense line $SL_i$ is set to the predefined SET voltage, typically 2 V for OxRAM. The corresponding word line $WLw_j$, $WL_{Mj}$ is set to a voltage chosen to limit the current to a compliance value, ranging from 20 to 200 μA depending on the chosen programming condition.

As a variant, to apply the SET pulse to a respective memory component $W_{BLb,ij}$, $W_{BL,ij}$, $M_{BLb,ij}$, $M_{BL,ij}$, the corresponding bit line $BLb_j$, $BL_j$ is set to the predefined SET voltage, while the sense line $SL_i$ is set to the ground.

To apply the RESET pulse to a respective memory component $W_{BLb,ij}$, $W_{BL,ij}$, $M_{BLb,ij}$, $M_{BL,ij}$, in particular to a PCM device, the corresponding bit line $BLb_j$, $BL_j$ is set to the ground, while the sense line $SL_i$ is set to a predefined RESET voltage, higher than to the predefined SET voltage, with as shorter duration than for the SET pulse.

As a variant, to apply the RESET pulse to a respective memory component $W_{BLb,ij}$, $W_{BL,ij}$, $M_{BLb,ij}$, $M_{BL,ij}$, the corresponding bit line $BLb_j$, $BL_j$ is set to the predefined RESET voltage, while the sense line $SL_i$ is set to the ground.

Alternatively, when the respective memory component $W_{BLb,ij}$, $W_{BL,ij}$, $M_{BLb,ij}$, $M_{BL,ij}$, is an OxRAM device, to apply the RESET pulse, a voltage of opposite sign needs to be applied to the respective memory component $W_{BLb,ij}$, $W_{BL,ij}$, $M_{BLb,ij}$, $M_{BL,ij}$, and the current compliance is not needed. The sense line $SL_i$ is therefore set to the ground, while the corresponding word line $WLw_j$, $WL_{Mj}$ is set to a value of 3.3 V, and the corresponding bit line $BLb_j$, $BL_j$ is set to a "RESET voltage", chosen for example between 1.5 V and 2.5 V.

During programming such operations, all bit $BLb_j$, $BL_j$, sense $SL_i$ and word $WL_{Wj}$, $WL_{Mj}$ lines corresponding to non-selected memory component $W_{BLb,ij}$, $W_{BL,ij}$, $M_{BLb,ij}$, $M_{BL,ij}$ are grounded, with the exception of the bit line $BLb_j$, $BL_j$ of the complementary memory component $W_{BL,ij}$, $W_{BLb,ij}$, $M_{BL,ij}$, $M_{BLb,ij}$ of the selected memory component $W_{BLb,ij}$, $W_{BL,ij}$, $M_{BLb,ij}$, $M_{BL,ij}$: this one is programmed to the same voltage as the one applied to the sense line $SL_i$ to avoid any disturbing effect on the complementary device.

In addition, the training of the binarized neural network is better if the conductance $G(W_{BLb,ij})$, $G(W_{BL,ij})$, $G(M_{BLb,ij})$, $G(M_{BL,ij})$ of a respective memory component $W_{BLb,ij}$, $W_{BL,ij}$, $M_{BLb,ij}$, $M_{BL,ij}$ is modified progressively, in particular for the conductance $G(M_{BLb,ij})$, $G(M_{BL,ij})$ of the respective secondary memory components $M_{BLb,ij}$, $M_{BL,ij}$ used to encode the respective latent variable $m_{ij}$.

Such a progressive modification of the conductance $G(W_{BLb,ij})$, $G(W_{BL,ij})$, $G(M_{BLb,ij})$, $G(M_{BL,ij})$ is for example obtained by applying the same SET pulse at multiple successive time instants, thereby allowing to gradually change the conductance. Even if the SET pulse is in principle longer than the RESET pulse, the applied SET pulse has preferably a relatively short duration, for example a duration comprised between 100 ns and 200 ns.

During this weight update step 220, the electronic circuit 10, in particular via the first and second control modules 22, 24, is therefore configured to carry out the following operations:

- a read operation for reading the values of the complementary primary memory components $W_{BLb,ij}$, $W_{BL,ij}$, to obtain the binary weight $W_{bin,ij}$ value;
- a write operation for writing values into the complementary secondary memory components $M_{BLb,ij}$, $M_{BL,ij}$, to encode the latent variable $m_{ij}$, typically according to aforementioned equation (3);
- successive read operations, namely the first read and then the second read as described above, to compare the $(G(M_{BLb,ij}) - G(M_{BL,ij}))$ conductance difference with the threshold; and

when applicable depending on the result of the previous comparison, a write operation for writing values into the complementary primary memory components $W_{BLb,ij}$, $W_{BL,ij}$, to switch from $G(W_{BLb,ij}) < G(W_{BL,ij})$ to $G(W_{BLb,ij}) > G(W_{BL,ij})$, or else to switch from $G(W_{BL,ij})<G(W_{BLb,ij})$ to $G(W_{BL,ij}) > G(W_{BLb,ij})$, so as to update the binary weight $W_{bin,ij}$ value if necessary.

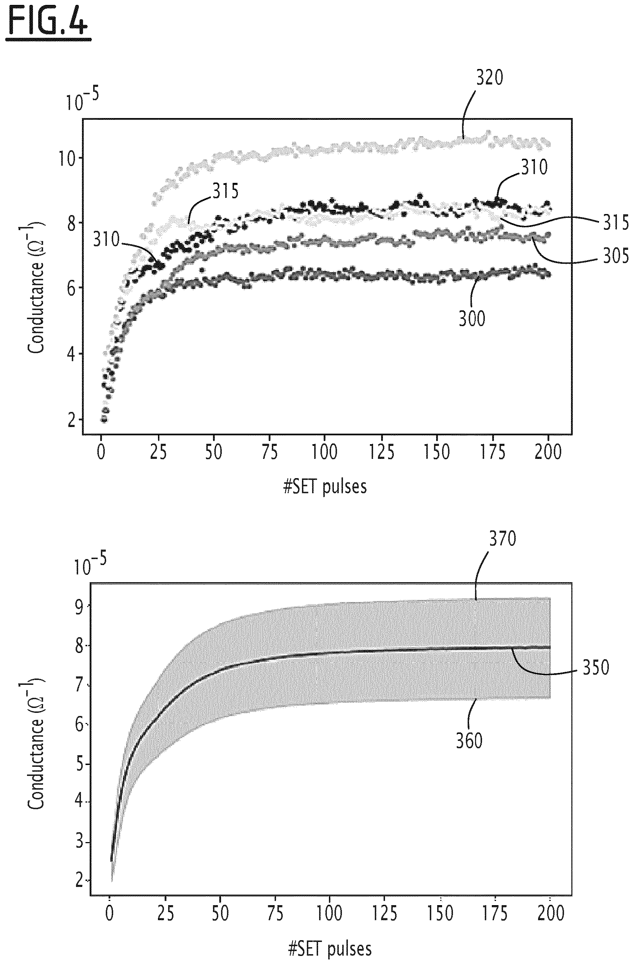

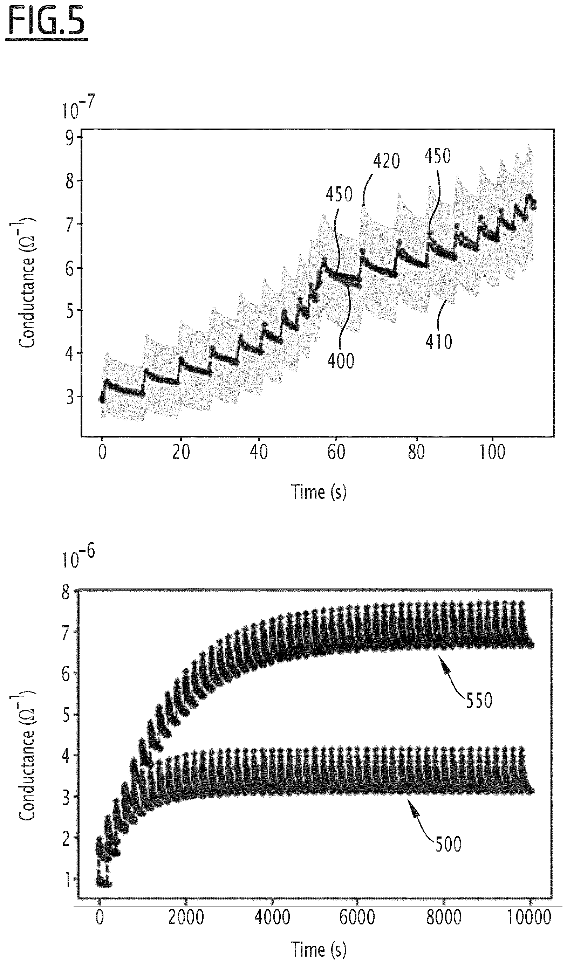

As shown in Figures 4 and 5, the resulting gradual change in conductance is very smooth and reproducible.

In Figure 4, various curves 300, 305, 310, 315 and 320 show a progressive increase of the conductance for various memory components, of the type of the memory components $W_{BLb,ij}$, $W_{BL,ij}$, $M_{BLb,ij}$, $M_{BL,ij}$, included in the memory cells 20. Further to multiple measures obtained for a high number of memory components, such as 4096 memory components, a mean curve 350 representing the mean of said measured conductances, together with a lower curve 360 and an upper curve 370 representing the standard deviation of said measured conductances from this mean were obtained. These mean curve 350, lower curve 360 and upper curve 370 confirm the obtained progressive increase of the conductance for such memory components.

In Figure 5, a set of curves showing alternating increases and decreases over time in the conductance of said memory components included in the memory cells 20, the conductance increases being obtained with SET pulses and the conductance decreases being due to time drifts. In the example of Figure 5, SET pulses were applied in successive time instants, namely at 10s, 19s, 28s, etc, for a high number of memory components, such as 4096 memory components, while measuring the conductance; and the results are a mean curve 400 representing the mean of said measured conductances, together with a lower curve 410 and an upper curve 420 representing the standard deviation of said measured conductances from this mean. A model curve 450 represents a modeled evolution of the conductance in these conditions, i.e. with SET pulses applied in successive time instants 10s, 19s, 28s, etc. The comparison of the mean curve 400, lower curve 410 and upper curve 420 with the model curve 450 shows that the model is in line with the measures.

Finally, the curves 500 and 550 represent the model of the drift and progressive SET pulses together, i.e. alternating increases and decreases over time in the conductance, for two respective memory components, such two complementary primary memory components $W_{BLb,ij}$, $W_{BL,ij}$, or else two complementary secondary memory components $M_{BLb,ij}$, $M_{BL,ij}$.

Therefore, said curves 500 and 550 confirm the ability to encode each binary weight $W_{bin,ij}$ using two complementary primary memory components $W_{BLb,ij}$, $W_{BL,ij}$, and respectively to encode each latent variable $m_{ij}$ is encoded using two complementary secondary memory components $M_{BLb,ij}$, $M_{BL,ij}$.

After the training phase 100, the electronic circuit 10 performs the inference phase 110 using the binarized neural network 15 trained during the training phase 100.

The inference phase 110 is performed in the same manner than the forward pass, with the binarized neural network 15 in its trained version, instead of the binarized neural network 15 in its initial untrained version. Accordingly, equation (1) is used for calculating the output values of the neurons of a respective current layer, from the input values received by the neurons of the respective current layer, namely the output values of the neurons of the previous layer.

Thus, with the electronic circuit 10 and the training method according to the invention, each latent variable $m_{ij}$ is encoded using at least one secondary memory component $M_{BLb,ij}$, $M_{BL,ij}$, each secondary memory component $M_{BLb,ij}$, $M_{BL,ij}$ having a characteristic, such as conductance, subject to a time drift.

Therefore, the value of each latent variable $m_{ij}$ drifts over time, in a similar manner to each latent weight verifying an exponential moving average of gradients according to the BOP algorithm for training BNN.

Thus, the electronic circuit 10 and the training method use this characteristic, such as the conductance, of the secondary memory components $M_{BLb,ij}$, $M_{BL,ij}$ subject to the time drift to adapt the BOP algorithm for training the binarized neural network 15, so as to enable a full on-chip training of the binarized neural network 15.

Accordingly, while it has not been possible to train a binarized neural network without computer support with the prior art training methods, the electronic circuit 10 and the training method according to the invention allow a complete on-chip training of the binarized neural network 15 without computer support.

## Claims

1. Method for training a binarized neural network (15), the binarized neural network (15) including input neurons for receiving input values, output neurons for delivering output values and intermediate neurons between the input and output neurons, a respective binary weight ($W_{bin,ij}$) being associated to each connection between two respective neurons (30, 32), the method being implemented by an electronic circuit (10) and comprising:

   - a forward pass step (200) including calculating an output vector ($W_{bin}.X$) by applying the binarized neural network (15) on an input vector (X) in a forward direction (F1) from the input neurons to the output neurons;
   - a backward pass step (210) including computing an error vector (dY) between the calculated output vector

($W_{bin}$.X) and a learning output vector ($Y_{pred}$) and calculating a new value of the input vector (X) by applying the binarized neural network (15) on the error vector (dY) in a backward direction (F2) from the output neurons to the input neurons; and
- a weight update step (220) including, for each binary weight ($W_{bin,ij}$):

+ computing a product ($g_{t,ij}$) by multiplying a respective element of the error vector ($dY_i$) with a respective element of the new value of the input vector ($X_j$);
+ modifying a latent variable ($m_{ij}$) depending on the product ($g_{t,ij}$); and
+ updating the respective binary weight ($W_{bin,ij}$) as a function of the latent variable ($m_{ij}$) with respect to a threshold;

each binary weight ($W_{bin,ij}$) being encoded using at least one primary memory component ($W_{BLb,ij}$, $W_{BL,ij}$);
each latent variable ($m_{ij}$) being encoded using at least one secondary memory component ($M_{BLb,ij}$, $M_{BL,ij}$), each secondary memory component ($M_{BLb,ij}$, $M_{BL,ij}$) having a characteristic ($G(M_{BLb,ij})$, $G(M_{BL,ij})$) subject to a time drift.

2. Method according to claim 1, wherein each primary memory component ($W_{BLb,ij}$, $W_{BL,ij}$) has a characteristic ($G(W_{BLb,ij})$, $G(W_{BL,ij})$) subject to a time drift.

3. Method according to claim 1 or 2, wherein the characteristic subject to the time drift is a conductance ($G(W_{BLb,ij})$, $G(W_{BL,ij})$, $G(M_{BLb,ij})$, $G(M_{BL,ij})$).

4. Method according to any one of the preceding claims, wherein each binary weight ($W_{bin,ij}$) is encoded using two complementary primary memory components ($W_{BLb,ij}$, $W_{BL,ij}$) connected to a common sense line ($SL_j$).

5. Method according to claims 3 and 4, wherein each binary weight ($W_{bin,ij}$) depends on respective conductance ($G(W_{BLb,ij})$, $G(W_{BL,ij})$) of the two complementary primary memory components ($W_{BLb,ij}$, $W_{BL,ij}$).

6. Method according to claim 5, wherein each binary weight ($W_{bin,ij}$) verifies the following equation:

$$Wbin, ij = sign \left( \frac{G(W_{BLb,ij})}{G(W_{BL,ij})} \right)$$

where $W_{bin,ij}$ represents a respective binary weight,
sign is a sign function applied to an operand and issuing the value 1 if the operand is positive and -1 if the operand is negative, and
$G(W_{BLb,ij})$ and $G(W_{BL,ij})$ are the respective conductance of the two complementary primary memory components ($W_{BLb,ij}$, $W_{BL,ij}$).

7. Method according to any one of the preceding claims, wherein each latent variable ($m_{ij}$) is encoded using two complementary secondary memory components ($M_{BLb,ij}$, $M_{BL,ij}$) connected to a common sense line ($SL_j$).

8. Method according to claims 3 and 7, wherein each latent variable ($m_{ij}$) depends on respective conductances ($G(M_{BLb,ij})$, $G(M_{BL,ij})$) of the two complementary secondary memory components ($M_{BLb,ij}$, $M_{BL,ij}$).

9. Method according to claim 8, wherein each latent variable ($m_{ij}$) verifies the following equation:

$$m_{ij} = G\left(M_{BLb,ij}\right) - G\left(M_{BL,ij}\right)$$

where $m_{ij}$ represents a respective latent variable, and
$G(M_{BLb,ij})$ and $G(M_{BL,ij})$ are the respective conductance of the two complementary secondary memory components ($M_{BLb,ij}$, $M_{BL,ij}$).

10. Method according to any one of the preceding claims, wherein during the weight update step (220), each latent variable ($m_{ij}$) is modified depending on the sign of the respective product ($g_{t,ij}$),
each latent variable ($m_{ij}$) being preferably increased if the respective product ($g_{t,ij}$) is positive, and conversely decreased if said product ($g_{t,ij}$) is negative.

11. Method according to claims 5 and 8, wherein during the weight update step (220), each binary weight ($W_{bin,ij}$) is updated according to an algorithm including following first and second cases:

first case: **if** $G(W_{BLb,ij}) < G(W_{BL,ij})$ and $G(M_{BLb,ij}) > G(M_{BL,ij})$ + Threshold1 **then** switch to $G(W_{BLb,ij}) > G(W_{BL,ij})$, preferably by increasing $G(W_{BLb,ij})$
Threshold1 being preferably equal to $(G(W_{BLb,ij}) - G(W_{BL,ij}))$;
second case: **if** $G(W_{BL,ij}) < G(W_{BLb,ij})$ and $G(M_{BL,ij}) > G(M_{BLb,ij})$ + Threshold2 **then** switch to $G(W_{BL,ij}) > G(W_{BLb,ij})$, preferably by increasing $G(W_{BL,ij})$,
Threshold2 being preferably equal to $(G(W_{BL,ij}) - G(W_{BLb,ij}))$);
where $G(W_{BLb,ij})$ and $G(W_{BL,ij})$ are the respective conductance of the two complementary primary memory components ($W_{BLb,ij}$, $W_{BL,ij}$),
$G(M_{BLb,ij})$ and $G(M_{BL,ij})$ are the respective conductance of the two complementary secondary memory components ($M_{BLb,ij}$, $M_{BL,ij}$), and
Threshold1, Threshold2 are respective thresholds;
the algorithm preferably consisting of said first and second cases.

12. Method according to any one of the preceding claims, wherein each one of the primary ($W_{BLb}$, $W_{BL}$) and secondary ($M_{BLb}$, $M_{BL}$) memory components is a phase-change memory device.

13. Method according to claim 12, wherein increasing the conductance ($G(W_{BLb,ij})$, $G(W_{BL,ij})$, $G(M_{BLb,ij})$, $G(M_{BL,ij})$) of a respective memory component ($W_{BLb,ij}$, $W_{BL,ij}$, $M_{BLb,ij}$, $M_{BL,ij}$) is obtained by applying a SET pulse to the corresponding phase-change memory device;
the SET pulse being preferably a low current pulse with a long duration, and
a RESET pulse being a high current pulse with a short duration.

14. Electronic circuit (10) for operating a binarized neural network (15), the binarized neural network (15) including input neurons for receiving input values, output neurons for delivering output values and intermediate neurons between the input and output neurons, a respective binary weight ($W_{bin,ij}$) being associated to each connection between two respective neurons (30, 32), a training of the binarized neural network (15) comprising:

- a forward pass including calculating an output vector ($W_{bin}.X$) by applying the binarized neural network (15) on an input vector ($X$) in a forward direction (F1) from the input neurons to the output neurons;
- a backward pass including computing an error vector ($dY$) between the calculated output vector ($W_{bin}.X$) and a learning output vector ($Y_{pred}$) and calculating a new value of the input vector ($X$) by applying the binarized neural network (15) on the error vector ($dY$) in a backward direction (F2) from the output neurons to the input neurons; and
- a weight update including, for each binary weight ($W_{bin,ij}$), computing a product ($g_{t,ij}$) by multiplying a respective element of the error vector ($dY_i$) with a respective element of the new value of the input vector ($X_j$); modifying a latent variable ($m_{ij}$) depending on the product ($g_{t,ij}$); and updating the respective binary weight ($W_{bin,ij}$) as a function of the latent variable ($m_{ij}$) with respect to a threshold;

the electronic circuit (10) comprising a plurality of memory cells (20), each memory cell (20) being associated to a respective binary weight ($W_{bin,ij}$), each memory cell (20) including at least one primary memory component ($W_{BLb,ij}$, $W_{BL,ij}$) for encoding the respective binary weight ($W_{bin,ij}$);
each memory cell (20) further including at least one secondary memory component ($M_{BLb,ij}$, $M_{BL,ij}$) for encoding a respective latent variable ($m_{ij}$), each latent variable ($m_{ij}$) being used for updating the respective binary weight ($W_{bin,ij}$), each secondary memory component ($M_{BLb,ij}$, $M_{BL,ij}$) having a characteristic ($G(M_{BLb,ij})$, $G(M_{BL,ij})$) subject to a time drift.

15. Electronic circuit (10) according to claim 14, wherein the electronic circuit (10) further comprises:

- a plurality of primary word lines ($WL_{Wj}$) to command the primary memory components ($W_{BLb,ij}$, $W_{BL,ij}$);
- a plurality of secondary word lines ($WL_{Mj}$) to command the secondary memory components ($M_{BLb,ij}$, $M_{BL,ij}$);
- a plurality of sense lines ($SL_j$) and bit lines ($BLb_i$, $BL_i$) connected to the memory cells (20);
- a first control module (22) to control the primary word lines ($WL_{Wj}$), the secondary word lines ($WL_{Mj}$) and the sense lines ($SL_j$); and
- a second control module (24) to control the bit lines ($BLb_i$, $BL_i$);

a respective sense line (SL$_j$) being preferably connected to both primary (W$_{BLb,ij}$, W$_{BL,ij}$) and secondary (M$_{BLb,ij}$, M$_{BL,ij}$) memory components of a corresponding memory cell (20);

a respective bit line (BLb$_i$, BL$_i$) being preferably connected to both primary (W$_{BLb,ij}$, W$_{BL,ij}$) and secondary (M$_{BLb,ij}$, M$_{BL,ij}$) memory components of a corresponding memory cell (20).

**Amended claims in accordance with Rule 137(2) EPC.**

1. Method for training a binarized neural network (15), the binarized neural network (15) including input neurons for receiving input values, output neurons for delivering output values and intermediate neurons between the input and output neurons, a respective binary weight (W$_{bin,ij}$) being associated to each connection between two respective neurons (30, 32), the method being implemented by an electronic circuit (10) and comprising:

   - a forward pass step (200) including calculating an output vector (W$_{bin}$.X) by applying the binarized neural network (15) on an input vector (X) in a forward direction (F1) from the input neurons to the output neurons;
   - a backward pass step (210) including computing an error vector (dY) between the calculated output vector (W$_{bin}$.X) and a learning output vector (Y$_{pred}$) and calculating a new value of the input vector (X) by applying the binarized neural network (15) on the error vector (dY) in a backward direction (F2) from the output neurons to the input neurons; and
   - a weight update step (220) including, for each binary weight (W$_{bin,ij}$):

      + computing a product (g$_{t,ij}$) by multiplying a respective element of the error vector (dYi) with a respective element of the new value of the input vector (X$_j$);
      + modifying a latent variable (m$_{ij}$) depending on the product (g$_{t,ij}$); and
      + updating the respective binary weight (W$_{bin,ij}$) as a function of the latent variable (m$_{ij}$) with respect to a threshold;

   each binary weight (W$_{bin,ij}$) being encoded using at least one primary memory component (W$_{BLb,ij}$, W$_{BL,ij}$);
   each latent variable (m$_{ij}$) being encoded using at least one secondary memory component (M$_{BLb,ij}$, M$_{BL,ij}$), each secondary memory component (M$_{BLb,ij}$, M$_{BL,ij}$) having a characteristic (G(M$_{BLb,ij}$), G(M$_{BL,ij}$)) subject to a time drift, wherein each one of the primary (W$_{BLb}$, W$_{BL}$) and secondary (M$_{BLb}$, M$_{BL}$) memory components is a phase-change memory device.

2. Method according to claim 1, wherein each primary memory component (W$_{BLb,ij}$, W$_{BL,ij}$) has a characteristic (G(W$_{BLb,ij}$), G(W$_{BL,ij}$)) subject to a time drift.

3. Method according to claim 1 or 2, wherein the characteristic subject to the time drift is a conductance (G(W$_{BLb,ij}$), G(W$_{BL,ij}$), G(M$_{BLb,ij}$), G(M$_{BL,ij}$)).

4. Method according to any one of the preceding claims, wherein each binary weight (W$_{bin,ij}$) is encoded using two complementary primary memory components (W$_{BLb,ij}$, W$_{BL,ij}$) connected to a common sense line (SL$_j$).

5. Method according to claims 3 and 4, wherein each binary weight (W$_{bin,ij}$) depends on respective conductance (G(W$_{BLb,ij}$), G(W$_{BL,ij}$)) of the two complementary primary memory components (W$_{BLb,ij}$, W$_{BL,ij}$).

6. Method according to claim 5, wherein each binary weight (W$_{bin,ij}$) verifies the following equation:

$$Wbin, ij = sign\left(\frac{G(W_{BLb,ij})}{G(W_{BL,ij})}\right)$$

where W$_{bin,ij}$ represents a respective binary weight,

sign is a sign function applied to an operand and issuing the value 1 if the operand is positive and -1 if the operand is negative, and
G(W$_{BLb,ij}$) and G(W$_{BL,ij}$) are the respective conductance of the two complementary primary memory components (W$_{BLb,ij}$, W$_{BL,ij}$).

7. Method according to any one of the preceding claims, wherein each latent variable ($m_{ij}$) is encoded using two complementary secondary memory components ($M_{BLb,ij}$, $M_{BL,ij}$) connected to a common sense line ($SL_j$).

8. Method according to claims 3 and 7, wherein each latent variable ($m_{ij}$) depends on respective conductances ($G(M_{BLb,ij})$, $G(M_{BL,ij})$) of the two complementary secondary memory components ($M_{BLb,ij}$, $M_{BL,ij}$).

9. Method according to claim 8, wherein each latent variable ($m_{ij}$) verifies the following equation:

$$m_{ij} = G\left(M_{BLb,ij}\right) - G\left(M_{BL,ij}\right)$$

where $m_{ij}$ represents a respective latent variable, and
$G(M_{BLb,ij})$ and $G(M_{BL,ij})$ are the respective conductance of the two complementary secondary memory components ($M_{BLb,ij}$, $M_{BL,ij}$).

10. Method according to any one of the preceding claims, wherein during the weight update step (220), each latent variable ($m_{ij}$) is modified depending on the sign of the respective product ($g_{t,ij}$),
each latent variable ($m_{ij}$) being preferably increased if the respective product ($g_{t,ij}$) is positive, and conversely decreased if said product ($g_{t,ij}$) is negative.

11. Method according to claims 5 and 8, wherein during the weight update step (220), each binary weight ($W_{bin,ij}$) is updated according to an algorithm including following first and second cases:

first case: **if** $G(W_{BLb,ij}) < G(W_{BL,ij})$ and $G(M_{BLb,ij}) > G(M_{BL,ij})$ + Threshold1 **then** switch to $G(W_{BLb,ij}) > G(W_{BL,ij})$, preferably by increasing $G(W_{BLb,ij})$
Threshold1 being preferably equal to ($G(W_{BLb,ij})$ - $G(W_{BL,ij})$);
second case: **if** $G(W_{BL,ij}) < G(W_{BLb,ij})$ and $G(M_{BL,ij}) > G(M_{BLb,ij})$ + Threshold2 **then** switch to $G(W_{BL,ij}) > G(W_{BLb,ij})$, preferably by increasing $G(W_{BL,ij})$,
Threshold2 being preferably equal to ($G(W_{BL,ij})$ - $G(W_{BLb,ij})$));
where $G(W_{BLb,ij})$ and $G(W_{BL,ij})$ are the respective conductance of the two complementary primary memory components ($W_{BLb,ij}$, $W_{BL,ij}$),
$G(M_{BLb,ij})$ and $G(M_{BL,ij})$ are the respective conductance of the two complementary secondary memory components ($M_{BLb,ij}$, $M_{BL,ij}$), and
Threshold1, Threshold2 are respective thresholds;
the algorithm preferably consisting of said first and second cases.

12. Method according to any one of the preceding claims, wherein increasing the conductance ($G(W_{BLb,ij})$, $G(W_{BL,ij})$, $G(M_{BLb,ij})$, $G(M_{BL,ij})$) of a respective memory component ($W_{BLb,ij}$, $W_{BL,ij}$, $M_{BLb,ij}$, $M_{BL,ij}$) is obtained by applying a SET pulse to the corresponding phase-change memory device;

the SET pulse being preferably a low current pulse with a long duration, and
a RESET pulse being a high current pulse with a short duration.

13. Electronic circuit (10) for operating a binarized neural network (15), the binarized neural network (15) including input neurons for receiving input values, output neurons for delivering output values and intermediate neurons between the input and output neurons, a respective binary weight ($W_{bin,ij}$) being associated to each connection between two respective neurons (30, 32), a training of the binarized neural network (15) comprising:

- a forward pass including calculating an output vector ($W_{bin}.X$) by applying the binarized neural network (15) on an input vector (X) in a forward direction (F1) from the input neurons to the output neurons;
- a backward pass including computing an error vector (dY) between the calculated output vector ($W_{bin}.X$) and a learning output vector ($Y_{pred}$) and calculating a new value of the input vector (X) by applying the binarized neural network (15) on the error vector (dY) in a backward direction (F2) from the output neurons to the input neurons; and
- a weight update including, for each binary weight ($W_{bin,ij}$), computing a product ($g_{t,ij}$) by multiplying a respective element of the error vector (dYi) with a respective element of the new value of the input vector ($X_j$); modifying a latent variable ($m_{ij}$) depending on the product ($g_{t,ij}$); and updating the respective binary weight ($W_{bin,ij}$) as a function of the latent variable ($m_{ij}$) with respect to a threshold;

the electronic circuit (10) comprising a plurality of memory cells (20), each memory cell (20) being associated to a respective binary weight ($W_{bin,ij}$), each memory cell (20) including at least one primary memory component ($W_{BLb,ij}$, $W_{BL,ij}$) for encoding the respective binary weight ($W_{bin,ij}$);

each memory cell (20) further including at least one secondary memory component ($M_{BLb,ij}$, $M_{BL,ij}$) for encoding a respective latent variable ($m_{ij}$), each latent variable ($m_{ij}$) being used for updating the respective binary weight ($W_{bin,ij}$), each secondary memory component ($M_{BLb,ij}$, $M_{BL,ij}$) having a characteristic ($G(M_{BLb,ij})$, $G(M_{BL,ij})$) subject to a time drift,

wherein each one of the primary ($W_{BLb}$, $W_{BL}$) and secondary ($M_{BLb}$, $M_{BL}$) memory components is a phase-change memory device.

14. Electronic circuit (10) according to claim 13, wherein the electronic circuit (10) further comprises:

- a plurality of primary word lines ($WLwj$) to command the primary memory components ($W_{BLb,ij}$, $W_{BL,ij}$);
- a plurality of secondary word lines ($WL_{Mj}$) to command the secondary memory components ($M_{BLb,ij}$, $M_{BL,ij}$);
- a plurality of sense lines ($SL_j$) and bit lines ($BLb_i$, $BL_i$) connected to the memory cells (20);
- a first control module (22) to control the primary word lines ($WLwj$), the secondary word lines ($WL_{Mj}$) and the sense lines ($SL_j$); and
- a second control module (24) to control the bit lines ($BLb_i$, $BL_i$);

a respective sense line ($SL_j$) being preferably connected to both primary ($W_{BLb,ij}$, $W_{BL,ij}$) and secondary ($M_{BLb,ij}$, $M_{BL,ij}$) memory components of a corresponding memory cell (20);

a respective bit line ($BLb_i$, $BL_i$) being preferably connected to both primary ($W_{BLb,ij}$, $W_{BL,ij}$) and secondary ($M_{BLb,ij}$, $M_{BL,ij}$) memory components of a corresponding memory cell (20).

# FIG.1

T1         T3        T4        T2

Vdd

CLK

$\overline{Out}$ = Outb

T5

T6

PCSA

Out

BLb                                BL

$WL_W$

$T_{Wb}$                                $T_W$

$W_{BLb}$     $W_{BL}$

20

$T_{Mb}$    $T_M$

$WL_M$

$M_{BLb}$     $M_{BL}$

BLb                    SL              BL

## FIG.2

Training   200

| Forward pass |

210

| Backward pass | 100

220

| Weight update |

| Inference | 110

## FIG.3

# FIG.4

# FIG.5

Europäisches
Patentamt

European
Patent Office

Office européen
des brevets

**EUROPEAN SEARCH REPORT**

Application Number

EP 21 30 5677

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | J\'ER\'EMIE LAYDEVANT ET AL: "Training Dynamical Binary Neural Networks with Equilibrium Propagation", ARXIV.ORG, CORNELL UNIVERSITY LIBRARY, 201 OLIN LIBRARY CORNELL UNIVERSITY ITHACA, NY 14853, 19 April 2021 (2021-04-19), XP081930333, * Sections 1, 3.1. and 3.4, Algorithms 1 and 2 * | 1-10, 12-15 | INV. G06N3/063 G06N3/08 G11C11/00 |
| Y | HUANG PENG ET AL: "Hardware implementation of RRAM based binarized neural networks", APL MATERIALS, AMERICAN INSTITUTE OF PHYSICS, 2 HUNTINGTON QUADRANGLE, MELVILLE, NY 11747, vol. 7, no. 8, 5 August 2019 (2019-08-05), XP012239653, DOI: 10.1063/1.5116863 [retrieved on 2019-08-05] * the whole document * * figures 1,3,4 * | 2,4-9, 12,13,15 | |
| Y | Hirtzlin Tifenn ET AL: "Digital Biologically Plausible Implementation of Binarized Neural Networks With Differential Hafnium Oxide Resistive Memory Arrays", Frontiers in neuroscience, 1 January 2019 (2019-01-01), XP055848629, Switzerland DOI: 10.3389/fnins.2019.01383 Retrieved from the Internet: URL:https://www.frontiersin.org/articles/10.3389/fnins.2019.01383/full [retrieved on 2021-10-06] * Sections 1,2.1,2.2 * | 2,4-9, 12,13,15 | TECHNICAL FIELDS SEARCHED (IPC) G06N G11C |

-/--

The present search report has been drawn up for all claims

| Place of search | Date of completion of the search | Examiner |
|---|---|---|
| The Hague | 21 October 2021 | Targon, Valerio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 21 30 5677

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LABORIEUX AXEL ET AL: "Synaptic metaplasticity in binarized neural networks", NATURE COMMUNICATIONS, vol. 12, no. 1, 5 May 2021 (2021-05-05), XP055849986, DOI: 10.1038/s41467-021-22768-y Retrieved from the Internet: URL:https://www.nature.com/articles/s41467-021-22768-y.pdf> * Section "Results" on pages 3-6 * ----- | 1,14 | |
| A | QIN YI-FAN ET AL: "Design of High Robustness BNN Inference Accelerator Based on Binary Memristors", IEEE TRANSACTIONS ON ELECTRON DEVICES, IEEE SERVICE CENTER, PISACATAWAY, NJ, US, vol. 67, no. 8, 9 June 2020 (2020-06-09), pages 3435-3441, XP011800548, ISSN: 0018-9383, DOI: 10.1109/TED.2020.2998457 [retrieved on 2020-07-22] * Sections II and III * ----- | 1-15 | |

TECHNICAL FIELDS
SEARCHED (IPC)

The present search report has been drawn up for all claims

| Place of search | Date of completion of the search | Examiner |
|---|---|---|
| The Hague | 21 October 2021 | Targon, Valerio |

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **T. HIRTZLIN et al.** Digital Biologically Plausible Implementation of Binarized Neural Networks with Differential Hafnium Oxide Resistive Memory Arrays. *Fontiers in Neuroscience,* 2020
- **K. HELWEGEN et al.** Latent Weights Do Not Exist: Rethinking Binarized Neural Network Optimization. *33rd Conference on Neural Information Processing Systems (NeurIPS 2019),* 2019
- **S. AMBROGIO et al.** Equivalent-accuracy accelerated neural-network training using analogue memory. *Nature,* 2018
- **T. HIRTZLIN et al.** Hybrid Analog-Digital Learning with Differential RRAM Synapses. *IEEE International Electron Devices Meeting,* 2019
- **Z. ZHOU et al.** A new hardware implementation approach of BNNs based on nonlinear 2T2R synaptic cell. *IEEE International Electron Devices Meeting,* 2018
- **T. HIRTZLIN.** *Hybrid Analog-Digital Learning with Differential RRAM Synapses*
- **T. HIRTZLIN.** *Digital Biologically Plausible Implementation of Binarized Neural Networks with Differential Hafnium Oxide Resistive Memory Arrays*